(19) Europäisches Patentamt
European Patent Office
Office européen des brevets

(11) EP 0 597 073 B1

(12) # EUROPÄISCHE PATENTSCHRIFT

(45) Veröffentlichungstag und Bekanntmachung des Hinweises auf die Patenterteilung:
**10.07.1996 Patentblatt 1996/28**

(21) Anmeldenummer: **93912717.1**

(22) Anmeldetag: **19.05.1993**

(51) Int Cl.6: **C23C 16/18**, C23C 16/30, C07F 9/50

(86) Internationale Anmeldenummer:
**PCT/EP93/01241**

(87) Internationale Veröffentlichungsnummer:
**WO 93/24675 (09.12.1993 Gazette 1993/29)**

(54) **BORHALTIGE ORGANISCHE GRUPPE-V-VERBINDUNGEN**

ORGANIC GROUP V COMPOUNDS CONTAINING BORON

COMPOSES ORGANIQUES BORES DU GROUPE V

(84) Benannte Vertragsstaaten:
**DE FR GB NL**

(30) Priorität: **29.05.1992 DE 4217735**

(43) Veröffentlichungstag der Anmeldung:
**18.05.1994 Patentblatt 1994/20**

(73) Patentinhaber: **MERCK PATENT GmbH**
**D-64271 Darmstadt (DE)**

(72) Erfinder:
- **POHL, Ludwig**
  **D-6100 Darmstadt (DE)**
- **SCHUMANN, Herbert**
  **D-1000 Berlin 49 (DE)**
- **MARSCHALL, Christian**
  **D-1000 Berlin 49 (DE)**

(56) Entgegenhaltungen:
**EP-A- 0 450 125**

EP 0 597 073 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft die Verwendung von borhaltigen organischen Gruppe-V-Verbindungen für die Herstellung dünner Filme oder epitaktischer Schichten durch Abscheidung der Elemente der V. Hauptgruppe auf Substraten durch Gasphasenabscheidung.

Die Abscheidung solcher Schichten aus entweder reinen Elementen der V. Gruppe oder meist aus Kombinationen mit anderen Elementen, wie z.B. Galliumarsenid, Indiumphosphid oder Galliumphosphid, kann zur Herstellung von elektrischen, elektronischen, optischen und optoelektronischen Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition (MOCVD) Methode, die Plasma-Ephanced-Metal-Organic Chemical Vapour Deposition (PE-MOCVD) Methode, die Photo-Metal-Organic Vapour Phase (Photo-MOVP) Methode, bei welcher die Substanzen durch UV-Bestrahlung zersetzt werden, die Laser-Chemical Vapour Deposition (Laser CVD) Methode oder die Metal-Organic Magnetron Scattering (MOMS) Methode in Frage. Die Vorteile gegenüber anderen Methoden sind ein kontrollierbares Schichtenwachstum, eine genaue Dotierungskontrolle sowie eine aufgrund der Normaloder Niederdruckbedingungen einfache Handhabung und Produktionsfreundlichkeit. Ferner ermöglicht diese Methode eine einfache Massenproduktion.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren, und somit ist auch ein kontrolliertes Wachsen der dünnen Schicht möglich.

Die anderen Methoden der Gasphasenabscheidung unterscheiden sich hiervon im wesentlichen nur durch die Art der Zuführung der für die Zersetzung erforderlichen Energie.

Bislang werden in den Standard-MOCVD-Prozessen für die Erzeugung von Schichten, die Elemente der Gruppe V enthalten, hauptsächlich beispielsweise $ASH_3$ oder $PH_3$ eingesetzt, die jedoch große Nachteile wie Toxizität und Selbstentzündlichkeit aufweisen. Daher sind für ihre Herstellung, den Transport, die Lagerung und die Anwendung dieser Verbindungen aufwendige Vorsichtsmaßnahmen notwendig.

Aufgabe der vorliegenden Erfindung war es daher, geeignete alternative, möglichst flüssige, Gruppe-V-Organyle zu finden, die nicht mehr pyrophor sind, sich aber aus der Gasphase zersetzen lassen, also für die verschiedenen Methoden der Gasphasenabscheidung geeignet sind, und zwar unter drastisch reduziertem allgemeinen Gefahrenpotential.

Es wurde nun gefunden, daß mit Hilfe von Boranderivaten sowohl eine inter- als auch eine intramolekulare Adduktbildung mit Elementen der V. Hauptgruppe möglich ist, die zu koordinativ abgesättigten, niedrig schmelzenden und chemisch stabilen metalloidorganischen Verbindungen führt, die einen für Gasphasenabscheidungsprozesse geeigneten Dampfdruck aufweisen, nicht mehr selbstentzündlich sind, und somit die genannten Bedingungen hervorragend erfüllen.

EP-A-0 450 125 offenbart ein Verfahren zum Herstellen von mikrokristallin kubischen Bornitridschichten durch Plasma-CVD-Verfahrens mittels organischer Bor- und Stickstoff-haltiger Verbindungen. Diese BN-Schichten haben z. B. Bedeutung als Isolationsschichten in integrierten Schaltungen, als Maskenmembranen in der Röntgenlithographie sowie zur Hartstoffbeschichtung.

Gegenstand der Erfindung ist somit die Verwendung von bestimmten borhaltigen organischen Gruppe-V-Verbindungen zur Herstellung epitaktischer Schichten durch Abscheidung der Elemente der V. Hauptgruppe auf Substraten aus der Gasphase sowie ein entsprechendes Verfahren.

Ferner ist Gegenstand der Erfindung, daß man bei dem erfindungsgemäßen Verfahren während des Abscheidungsprozesses andere metallorganische Verbindungen, die unter den angewandten Reaktionsbedingungen gasförmig sind, zuführt.

Die borhaltigen organischen Gruppe-V-Verbindungen entsprechen den Formeln, I, II, III oder IV

$$(R^1)_{3-m}E\,(X\text{-}BR^2R^3)_m \qquad I$$

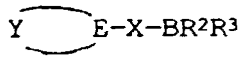

II

$$(R^5)_3EB(R^6)_3 \qquad III$$

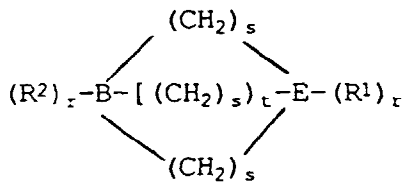

IV

worin

E Stickstoff, Phosphor, Arsen oder Antimon,

m 1, 2 oder 3,

X $-(CHR^4)_n-$

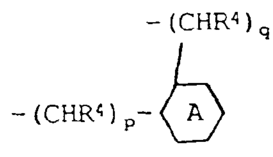

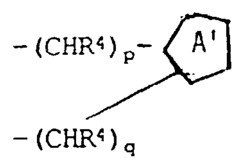

A einen Phenyl-, Cyclohexyl-, Cyclohexenyl- oder Cyclohexadienylring,

A' einen Cyclopentyl-, Cyclopentenyl- oder Cyclopentadienylring,

n 1, 2, 3, 4, 5 oder 6,

p und q jeweils unabhängig voneinander 0, 1, 2, 3 oder 4,

Y eine Alkylen- oder Alkylidengruppe mit 3-7 C-Atomen, worin auch ein oder mehrere H-Atome durch $R^5$ ersetzt sein können, wobei in der Alkylidengruppe eine oder mehrere nicht benachbarte Doppelbindungen vorhanden sein können,

s jeweils 1, 2, 3 oder 4,

r und t jeweils 0 oder 1, wobei

r + t 1 ist,

$R^1$, $R^2$, $R^3$, $R^5$ und $R^6$ jeweils unabhängig voneinander H, eine Alkylgruppe mit bis zu 8 C-Atomen, wobei diese Gruppe teilweise oder vollständig fluoriert sein kann, eine Cycloalkyl- oder Cycloalkenylgruppe mit 3-8 C-Atomen oder eine Arylgruppe
und

$R^4$ jeweils H oder eine Alkylgruppe mit 1-4 C-Atomen, die auch teilweise oder vollständig fluoriert sein kann

bedeuten.

Die koordinative Absättigung der Gruppe-V-Elemente kann intramolekular, wie in den Verbindungen der Formln I, II und IV, oder auch intermolekular, wie bei den Addukten der Formel III, erfolgen. In allen Fällen stellen diese Verbindungen niedrig schmelzende und chemisch stabile Verbindungen dar, die nicht mehr selbstentzündlich sind und einen für die Gasphasenabscheidung geeigneten Dampfdruck aufweisen.

Sie sind dadurch einfach handhabbare Verbindungen, die besonders vorteilhaft in der MOCVD-Technik eingesetzt werden können und den Herstellprozeß von Verbindungshalbleiter-Bauelementen wesentlich sicherer machen.

Die erfindungsgemäßen Verbindungen enthalten als Gruppe-V-Element vorzugsweise Stickstoff, Phosphor, Arsen oder Antimon.

In den Formeln I, II, III und IV bedeutet E insbesondere bevorzugt P, As oder Sb.

Die Reste $R^1$, $R^2$, $R^3$, $R^5$ und $R^6$ in den Formeln I, II, III und IV bedeuten vorzugsweise jeweils H oder eine geradkettige oder verzweigte Alkylgruppe mit 1-8 C Atomen, vorzugsweise mit 1-5 C Atomen. Die Alkylgruppen sind vorzugsweise geradkettig und bedeuten demnach bevorzugt Methyl, Ethyl, Propyl, Butyl, Pentyl, ferner auch Hexyl, Heptyl, Octyl, iso-Propyl, sek.-Butyl, tert.-Butyl, 2-Methylpentyl, 3-Methylpentyl oder 2-Octyl. Die Alkylreste können teilweise oder auch vollständig fluoriert sein und z.B. Monofluormethyl, Trifluormethyl, Difluorethyl, Trifluorehtyl, Pentafluorehtyl, Heptafluorpropyl, Nonafluorbutyl, Undecafluorpentyl oder Trifluorpropyl bedeuten. Vorzugsweise bedeuten nur ein oder zwei Reste H.

Falls $R^1$, $R^2$, $R^3$, $R^5$ und/oder $R^6$ eine Cycloalkyl- oder Cycloalkenylgruppe mit 3-8 C-Atomen bedeuten, so bedeuten sie vorzugsweise Cyclopropyl, Cyclobutyl, Cyclopentyl, Cyclopentenyl, Cylcohexyl, Cyclohexenyl, Cyclohexadienyl, Cycloheptyl, Cycloheptenyl, Cycloheptadienyl, Cyclooctyl, Cyclooctenyl, Cyclooctadienyl, Cyclooctatrienyl oder Cyclooctatetraenyl.

Weiterhin sind Verbindungen der Formeln I bis IV bevorzugt, worin $R^1$, $R^2$, $R^3$, $R^5$ und/oder $R^6$ eine Arylgruppe bedeuten. Dabei ist vorzugsweise Aryl gleichbedeutend mit einer Phenylgruppe. Diese Phenylgruppe kann auch substituiert vorliegen. Da diese Substituenten keinen wesentlichen Einfluß auf den angestrebten Verwendungszweck ausüben, sind alle Substituenten erlaubt, die keinen störenden Einfluß auf die Zersetzungsreaktion haben.

In Formel I bedeutet m 1, 2 oder 3, vorzugsweise 1 oder 2.

X in Formel I bedeutet vorzugsweise $-(CHR^4)_n-$ mit n = 1, 2, 3, 4, 5 oder 6, vorzugsweise ist n = 2, 3 oder 4.

Falls n = 1 ist, erfolgt die Stabilisierung meist inter molekular.

$R^4$ stellt entweder ein H-Atom oder vorzugsweise eine geradkettige Alkylgruppe dar, die auch teilweise oder vollständig fluoriert sein kann, mit 1-4 C-Atomen und bedeutet demnach vorzugsweise Methyl, Ethyl, Propyl, Butyl, Trifluormethyl, Tetrafluorethyl, Pentafluorehtyl oder Heptafluorpropyl. Falls $R^4$ eine Alkyl- oder teilweise oder vollständig fluorierte Alkylgruppe ist, so ist vorzugsweise nur ein $R^4$ in $-(CHR^4)_n-$eine Alkylgruppe, die anderen bedeuten dann H.

Ferner sind Verbindungen der Formel I bevorzugt, worin X die Bedeutung

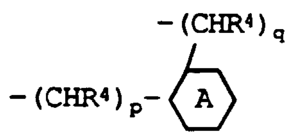

oder

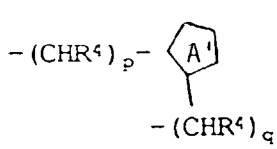

hat, worin p und q jeweils unabhängig voneinander 0, 1, 2, 3 oder 4, vorzugsweise 0, 1 oder 2 bedeuten. p + q bedeutet vorzugsweise 0, 1, 2, 3 oder 4, insbesondere bevorzugt 1 oder 2.

A bedeutet bevorzugt einen Phenyl- oder Cyclohexylring, ferner auch einen Cyclohexenyl- oder Cyclohexadienylring, wobei die Doppelbindungen im Cyclohexanring beliebig angeordnet sein können.

A' bedeutet vorzugsweise einen Cyclopentyl- oder Cyclopentadienylring, ferner auch einen Cyclopentenylring, wobei auch hier die Doppelbindungen im Ring beliebig angeordnet sein können.

In den Verbindungen der Formel I sind je nachdem welche Bedeutung m hat, jeweils mehrere Gruppen von $R^1$

bzw. ($X$-$BR^2R^3$) vorhanden. Diese Gruppen können dann jeweils verschiedene oder gleiche Bedeutung haben. Vorzugsweise haben die $R^1$-Gruppen bzw. die ($X$-$BR^2R^3$)-Reste die gleiche Bedeutung.

Beispielhafte Vertreter der Verbindungen der Formel I sind diejenigen der Formeln I1 bis I60:

$(R^1)_2N\text{-}(CHR^4)_n\text{-}BR^2R^3$ I1

$(R^1)_2P\text{-}(CHR^4)_n\text{-}BR^2R^3$ I2

$(R^1)_2As\text{-}(CHR^4)_n\text{-}BR^2R^3$ I3

$(R^1)_2Sb\text{-}(CHR^4)_n\text{-}BR^2R^3$ I4

$(R^1)_2N\text{-}(CH_2)_n\text{-}BR^2R^3$ I5

$(R^1)_2P\text{-}(CH_2)_n\text{-}BR^2R^3$ I6

$(R^1)_2As\text{-}(CH_2)_n\text{-}BR^2R^3$ I7

$(R^1)_2Sb\text{-}(CH_2)_n\text{-}BR^2R^3$ I8

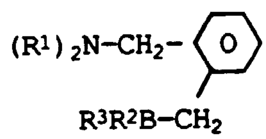

I9

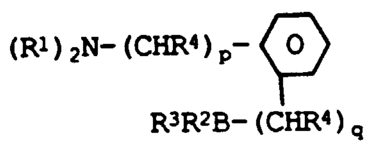

I10

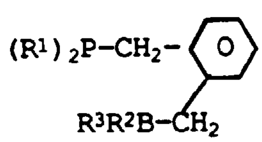

I11

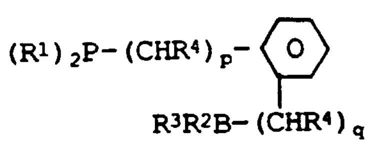

I12

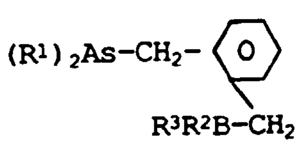

I13

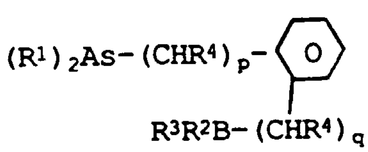

I14

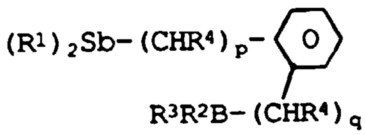

I15

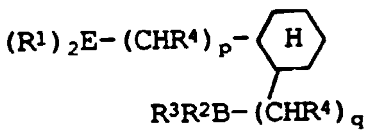

I16

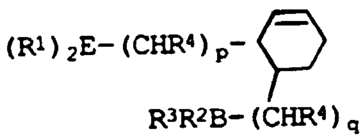

I17

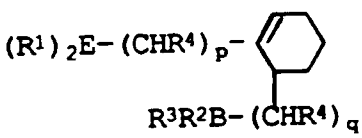

I18

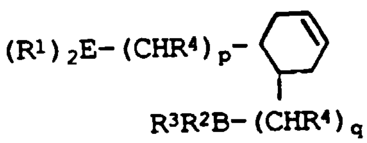

I19

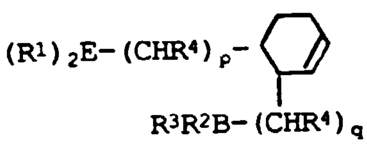

I20

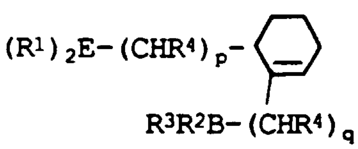

I21

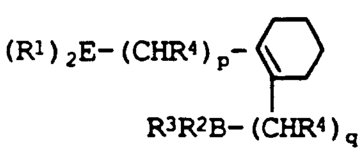

I22

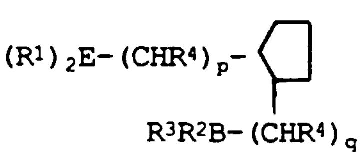

I23

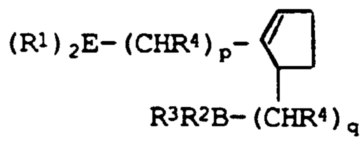

I24

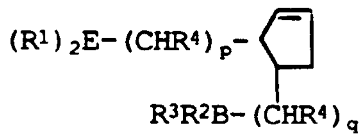

I25

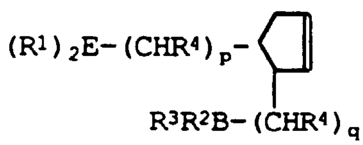

I26

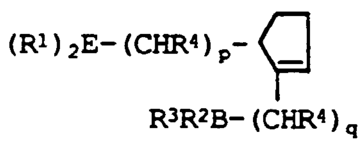

I27

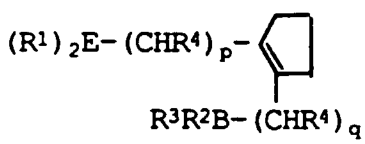

I28

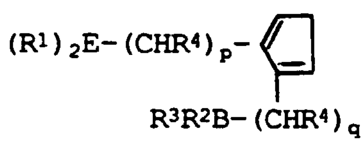

I29

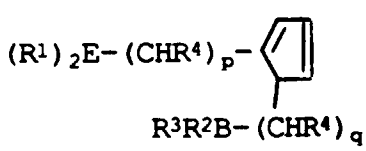

I30

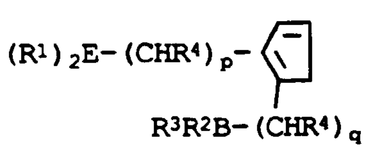

I31

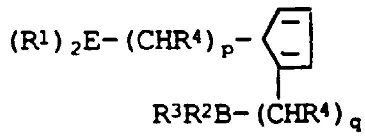

I32

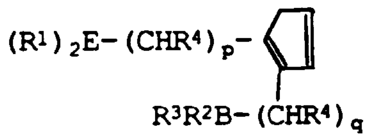

I33

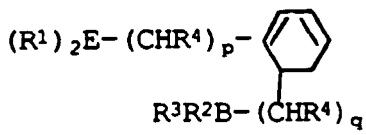

I34

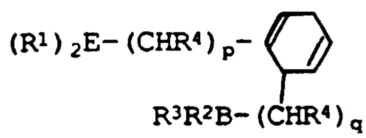

I35

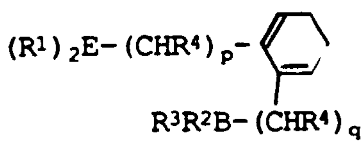

I36

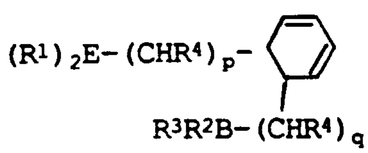

I37

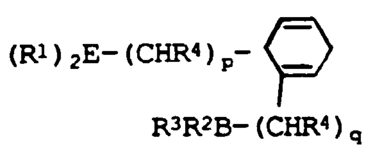

I38

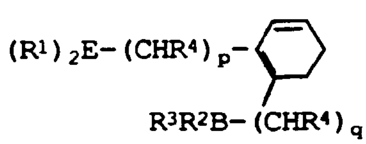

I39

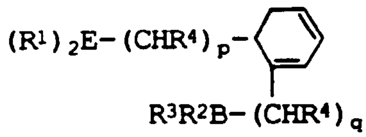

I40

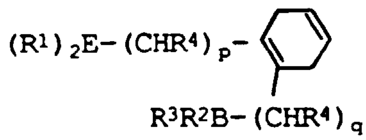

I41

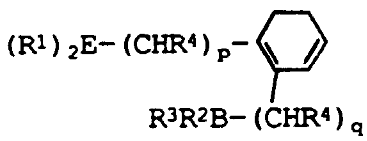

I42

$R^1N[-(CHR^4)_n-BR^2R^3]_2$ I43

$R^1P[-(CHR^4)_n-BR^2R^3]_2$ I44

$R^1As[-(CHR^4)_n-BR^2R^3]_2$ I45

$R^1Sb[-(CHR^4)_n-BR^2R^3]_2$ I46

$N[-(CHR^4)_n-BR^2R^3]_3$ I47

$P[-(CHR^4)_n-BR^2R^3]_3$ I48

$As[-(CHR^4)_n-BR^2R^3]_3$ I49

$Sb[-(CHR^4)_n-BR^2R^3]_3$ I50

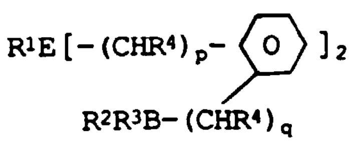

I51

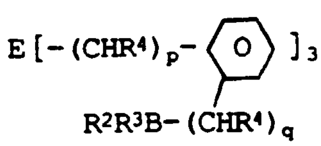

I52

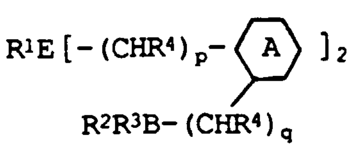

I53

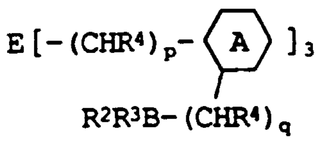

I54

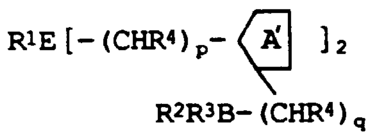

I55

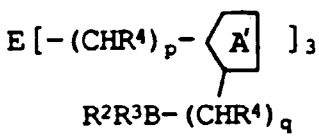

I56

$(Phenyl)_2P-(CH_2)_3-B(C_2H_5)_2$ I57

$(t-Butyl)_2P-(CH_2)_3-B(C_2H_5)_2$ I58

$H_2P-(CH_2)_3-BH_2$ I59

$t-Butyl-P[(CH_2)_3-B(C_2H_5)_2]_2$ I60

In den Formeln I53 und I54 kann A jeweils die Bedeutungen aus den Formeln I16 bis I22 und I34 bis I42 annehmen. In den Formeln I55 und I56 kann B jeweils die Strukturen, angegeben in den Formeln I23 bis I33, bedeuten.

Unter den Verbindungen der Formeln I1 bis I60 sind diejenigen der Formeln I2, I5,I6, I7, I8, I12, I14, I16, I23, I32, I37, I57, I58, I59 und I60 besonders bevorzugt.

In Formel II haben $R^2$, $R^3$ und X die bereits angegebenen bevorzugten Bedeutungen.

Y bedeutet vorzugsweise eine Alkylengruppe mit 3-7 C-Atomen und bedeutet demnach Propylen, Butylen, Pentylen, Hexylen oder Heptylen, wobei diese Alkylengruppen ferner auch durch $R^5$ substituiert sein können.

Ferner bedeutet Y auch eine Alkylidengruppe mit 3-7 C Atomen, wobei eine odere mehrere nicht benachbarte Doppelbindungen vorhanden sein können. Y bedeutet demnach bevorzugt auch

$-CH=CH-CH_2-$ Propyliden

$-CH_2-CH=CH-CH_2-$ Butyliden-(2)

$-CH=CH-CH_2-CH_2-$ Butyliden-(1)

$-CH_2-CH_2-CH=CH-CH_2-$ Pentyliden-(2)

$-CH_2-CH=CH-CH=CH-$

$-CH=CH-CH=CH-$

$-CH=CH-CH_2-CH=CH-$

$-CH_2-CH=CH-CH_2-CH_2-CH_2-$ Hexyliden-(2)

$-CH_2-CH_2-CH=CH-CH_2-CH_2-$ Hexyliden-(3)

$-CH_2-CH=CH-CH_2-CH=CH-$

| | |
|---|---|
| $-CH_2-CH=CH-CH_2-CH_2-CH_2-CH_2-$ | Heptyliden-(2) |
| $-CH_2-CH_2-CH=CH-CH_2-CH_2-CH_2-$ | Heptyliden-(3) |
| $-CH_2-CH=CH-CH_2-CH=CH-CH_2-$ | |
| $-CH=CH-CH_2-CH=CH-CH=CH-$ | |

Auch in den Alkylidengruppen können ein oder mehrere H-Atome durch $R^5$ ersetzt sein.
Beispielhafte, bevorzugte Vertreter der Verbindungen der Formel II sind diejenigen der Formeln II1 bis II21:

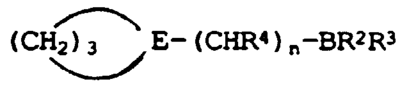

II1

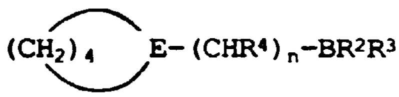

II2

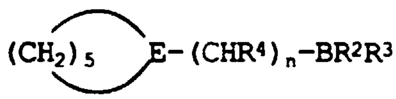

II3

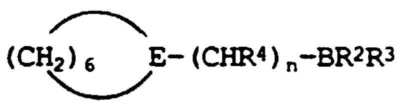

II4

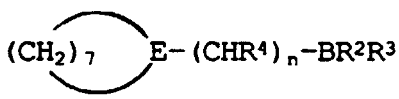

II5

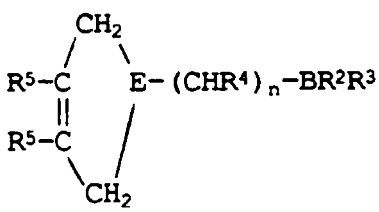

II6

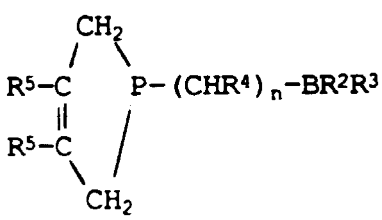

II7

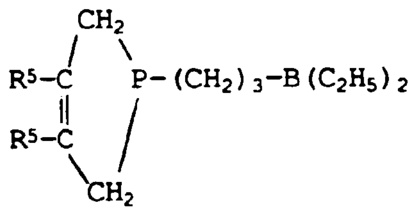

II8

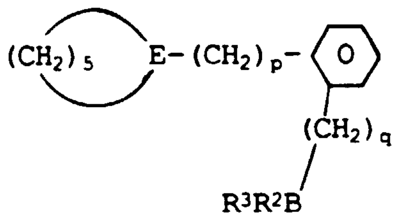

II9

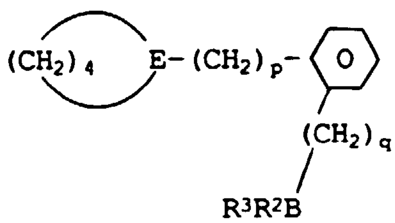

II10

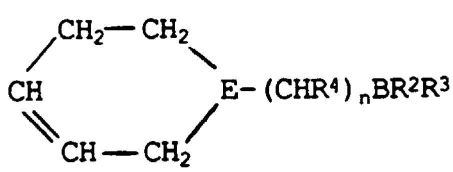

II11

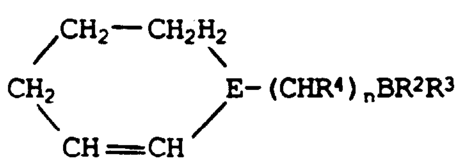

II12

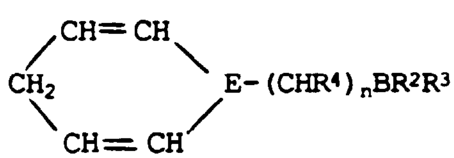

II13

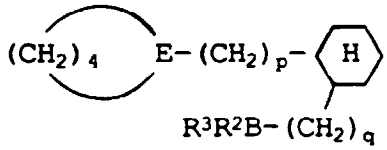

II14

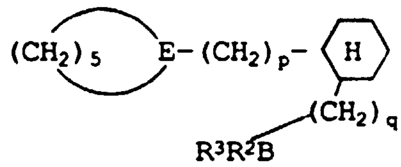

II15

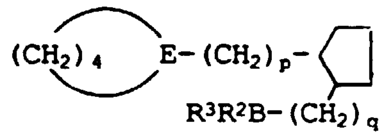

II16

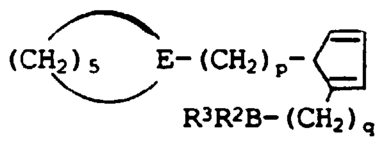

II17

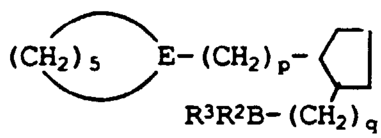

II18

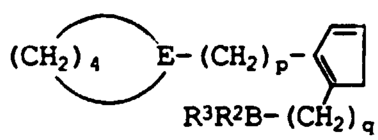

II19

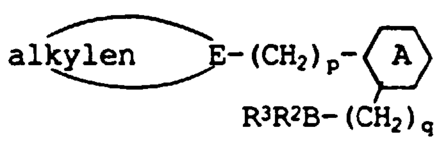

II20

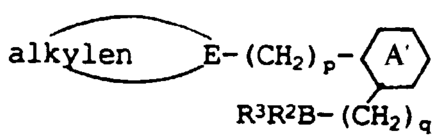

II21

Darunter sind diejenigen Verbindungen der Formeln II2, II3, II4, II6, II7, II8, II9, II10, II14 und II15 besonders bevc zugt.

In den Addukten der Formel III bedeuten E, $R^5$ und $R^6$ die bereits beschriebenen bevorzugten Bedeutungen. $R^5$ und $R^6$ können dabei jeweils entweder dreimal diesselbe oder unterschiedliche Bedeutungen haben. Die folgenden Unterformeln III1 bis III18 stellen bevorzugte Vertreter dieses Verbindungstyps her:

$(t\text{-Butyl})_2\ PHBH_3$ III1

$t\text{-ButylPH}_2\ B(Alkyl)_3$ III2

$(Phenyl)_2PH\ B(Alkyl)_3$ III3

$(Ethyl)_2PH\ B(Alkyl)_3$ III4

$(Butyl)_2AsH\ B(Alkyl)_3$ III5

$Butyl\ AsH_2\ B(Alkyl)_3$ III6

$(Pentyl)_2AsH\ B(Alkyl)_3$ III7

$(Ethyl)_2NH\ B(Alkyl)_3$ III8

$Ethyl\ NH_2\ B(Alkyl)_3$ III9

$(i\text{-}Propyl)_2NH\ B(Alkyl)_3$ III10

$(Cyclohexyl)_2EH\ B(Alkyl)_3$ III11

$(Phenyl)_2EH\ B(Alkyl)_3$ III12

$(Phenyl)_3E\ B(Alkyl)_3$ III13

$Methyl\ EH_2\ B(Alkyl)_3$ III14

$(Ethyl)_3E\ B(Alkyl)_3$ III15

$(Phenyl)_2SbH\ B(Alkyl)_3$ III16

$(Alkyl)_3E\ B(Phenyl)_3$ III17

$(Ethyl)\ (Propyl)EH\ B(Alkyl)_3$ III18

Die Verbindungen der Formel IV weisen eine cyclische oder bicyclische Struktur auf und sind intramolekular stabilisiert.

In Formel IV bedeuten E, $R^1$ und $R^2$ die bereits beschriebenen bevorzugten Gruppen.

s in den $(CH_2)_s$-Gruppen kann unabhängig voneinander 1, 2, 3 oder 4 bedeuten. Vorzugsweise ist s 2 oder 3, und vorzugsweise hat s in den $(CH_2)$-Gruppen die gleiche Bedeutung.

r und t können jeweils 0 oder 1 sein, mit r + t = 1. Bevorzugt ist r = 1 und t = 0.

Die folgende Gruppe von Verbindungen stellen bevorzugte Vertreter dieser Substanzklasse dar:

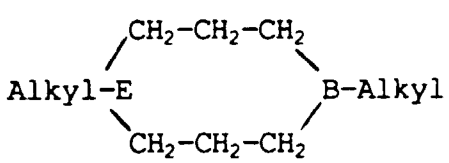

IV1

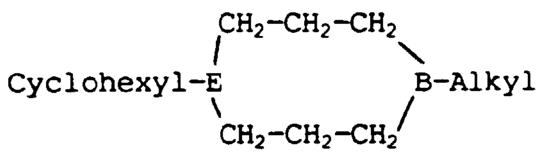

IV2

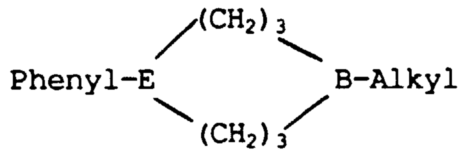

IV3

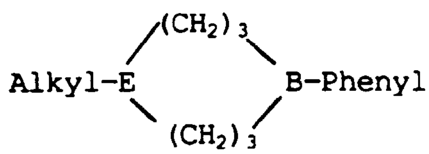

IV4

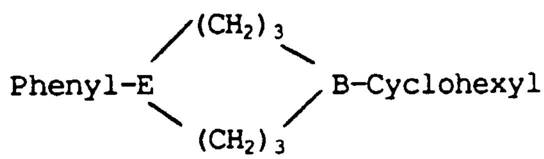

IV5

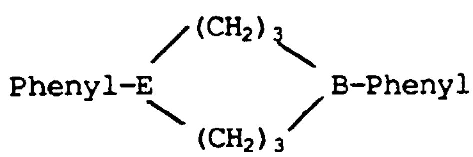

IV6

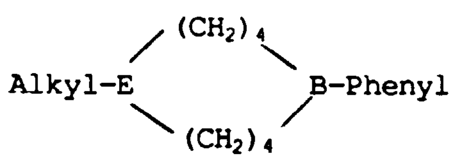

IV7

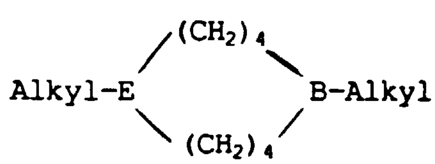

IV8

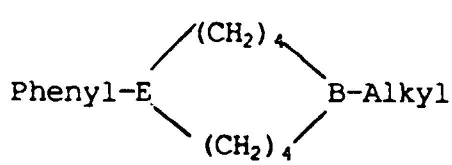

IV9

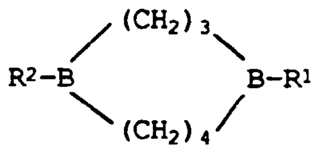

IV10

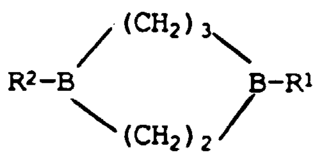

IV11

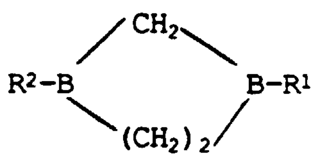

IV12

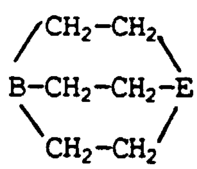

IV13

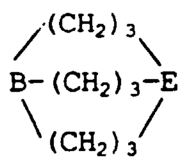

IV14

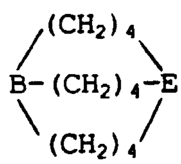

IV15

Die Verbindungen der Formeln I, II, III und IV sind hervorragend für die MOCVD-Epitaxie geeignet, da sie sich bei einfacher Handhabung bei höheren Temperaturen unter Freisetzung des entsprechenden Elements zersetzen. Sie sind ebenfalls für die anderen Methoden der Gasphasenabscheidung geeignet.

Die borhaltigen organische Gruppe-V-Verbindungen werden nach an sich bekannten Methoden hergestellt, wie sie in der Literatur (z.B. Houben-Weyl, Methoden der organischen Chemie, Georg Thieme Verlag, Stuttgart) beschrieben sind, und zwar unter Reaktionsbedingungen, die für die genannten Umsetzungen bekannt und geeignet sind. Dabei kann man auch von an sich bekannten, hier nicht näher erwähnten Varianten Gebrach machen.

Beispielsweise können Addukte der Formel III durch direkte Umsetzung der entsprechenden Borverbindungen B $(R^6)_3$mit den Verbindungen enthaltend das Element der V. Gruppe $E(R^5)_3$ hergestellt werden.

Ferner können die Verbindungen der Formeln I, II und IV z.B. hergestellt werden, indem man entsprechende Bor (alkyl)chloride mit einer entsprechenden Grignard-Verbindungen oder einem Akalimetallorganyl der entsprechenden Gruppe-V-Lewis-base in einem inerten Lösungsmittel einsetzt.

Die Umsetzungen erfolgen vorzugsweise in inerten Lösungsmitteln. Als Lösungsmittel kommen dabei alle diejenigen in Frage, die die Umsetzung nicht stören und nicht in das Reaktionsgeschehen eingreifen, wie beispielsweise Diethylether oder Tetrahydrofuran. Die Reaktionstemperaturen entsprechen im wesentlichen denen, die aus der Literatur für die Herstellung ähnlicher Verbindungen bekannt sind.

Beim erfindungsgemäßen Verfahren zur Herstellung dünner Filme oder epitaktischer Schichten auf beliebigen Substraten setzt man bei den an sich bekannten Gasphasenabscheidungs-Prozessen zur Abscheidung von Elementen der V. Hauptgruppe borhaltige organische Gruppe-V-Verbindungen, vorzugsweise diejenigen der Formeln I, II, III oder IV ein. Die Reaktionsbedingungen können analog den aus der Literatur bekannten und dem Fachmann geläufigen Werten gewählt werden.

Zur Herstellung von Verbindungshalbleitern, elektrischen, elektronischen, optischen und optoelektronischen Bauteilen können beim erfindungsgemäßen Verfahren während des Abscheidungsprozesses in der Zersetzungskammer eine oder mehrere unter den angewandten Reaktionsbedingungen gasförmige Verbindungen anderer Elemente des Periodensystems, vorzugsweise metallorganische Verbindungen von Aluminium, Gallium oder Indium zugesetzt werden. Eine weitere Variante des erfindungsgemäßen Verfahrens besteht darin, daß man während des Abscheidungsprozesses zusätzlich noch Dotierstoffe zusetzt. Als Dotierstoffe werden dabei flüchtige metallorganische Verbindungen von Eisen, Magnesium, Zink oder Chrom eingesetzt. Als gebräuchliche Verbindungen gelten dabei z.B. $Zn(CH_3)_2$, $Mg(CH_3)_2$ oder $Fe(C_5H_5)_2$.

Die folgenden Beispiele sollen die Erfindung näher erläutern. Temperaturangaben erfolgen in Grad Celsius. Fp. bedeutet Schmelzpunkt und Kp. Siedepunkt.

Beispiel 1

Zu einer Suspension von 5.98 g (73 mmol) $(CH_3)_2PCH_2Li$ (hergestellt durch Umsetzung von $P(CH_3)_3$ mit tert.-$C_4H_9Li$) in 100 ml Tetrahydrofuran werden bei -10 °C langsam 7,61 g (73 mmol) $ClB(C_2H_9)_2$ (herstellbar durch Umsetzung von $Al(C_2H_5)_3$ mit $BCl_3$) in 200 ml Tetrahydrofuran getropft. Nach vollendeter Zugabe läßt man noch zwei Stunden bei Raumtemperatur rühren, bevor das Lösungsmittel an der Vakuumpumpe abgezogen wird. Der Rückstand wird dann in Benzol aufgenommen und durch mehrmaliges Waschen mit entgastem Wasser vom ausgefallenden Niederschlag befreit. Die vereinten organische Phasen werden mit Natriumsulfat getrocknet, vom Trockenmittel befreit und abermals an der Vakuumpumpe eingeengt. Der Rückstand wird schließlich in Pentan aufgenommen. Es bildet sich ein weißer Niederschlag von Dimethylphosphinodiethylboramethan mit Fp. 120.1 °C.

Beispiel 2

In einem Kolben werden 6,09 g (37,75 mmol) Diphenylphosphan (hergestellt durch Umsetzung von LiAlH4 mit $(C_6H_5)_2PCl$) vorgelegt und auf ca. 110 °C erhitzt. Langsam läßt man nun 3,61 g (32,8 mmol) Diethylallylboran (erhalten durch Umsetzung von $(C_2H_5)_2BCl$ mit $C_3H_5MgBr$) hinzutropfen. Anschließend wird die Lösung noch weitere 5 Stunden bei 200 °C unter Rückfluß gekocht. Nach Erkalten des Reaktionsgemisches wird der ölige Rückstand fraktioniert destilliert. Das Produkt $(C_6H_5)_2PCH_2CH_2CH_2B(C_2H_5)_2$ destilliert in Form einer farblosen Flüssigkeit bei 145 °C und 0,06 mbar in die Vorlage über und wird bei -10 °C unter Argon aufbewahrt.

**Patentansprüche**

1. Verwendung von borhaltigen organischen Gruppe-V-Verbindungen der Formeln I, II, III oder IV

$$(R^1)_{3-m}E(X\text{-}BR^2R^3)_m \qquad \text{I}$$

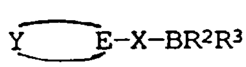

II

$$(R^5)_3EB(R^6)_3 \qquad \text{III}$$

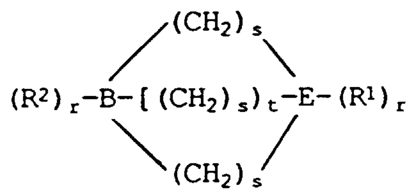 IV

worin

E Stickstoff, Phosphor, Arsen oder Antimon,

m 1, 2 oder 3,

X $-(CHR^4)_n-$

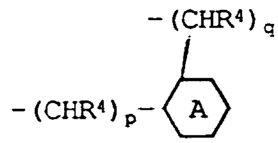

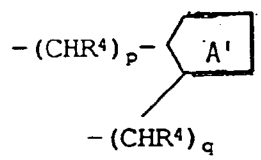 ,

A einen Phenyl-, Cyclohexyl-, Cyclohexenyl- oder Cyclohexadienylring,

A' einen Cyclopentyl-, Cyclopentenyl- oder Cyclopentadienylring,

n 1, 2, 3, 4, 5 oder 6,

p und q jeweils unabhängig voneinander 0, 1, 2, 3 oder 4,

Y eine Alkylen- oder Alkylidengruppe mit 3-7 C-Atomen, worin auch ein oder mehrere H-Atome durch $R^5$ ersetzt sein können, wobei in der Alkylidengruppe eine oder mehrere nicht benachbarte Doppelbindungen vorhanden sein können,

s jeweils 1, 2, 3 oder 4,

r und t jeweils 0 oder 1, wobei

r + t 1 ist,

$R^1$, $R^2$, $R^3$, $R^5$ und $R^6$ jeweils unabhängig voneinander H, eine Alkylgruppe mit bis zu 8 C-Atomen, wobei diese Gruppe teilweise oder vollständig fluoriert sein kann, eine Cycloalkyl- oder Cycloalkenylgruppe mit 3-8 C-Atomen oder eine Arylgruppe
und

$R^4$ jeweils H oder eine Alkylgruppe mit 1-4 C-Atomen, die auch teilweise oder vollständig fluoriert sein kann

zur Herstellung epitaktischer Schichten durch Elementabscheidung aus der Gasphase .

**2.** Verwendung der Verbindungen nach Anspruch 1 zur Herstellung epitaktischers Schichten in elektrischen, elektronischen, optischen und optoelektrischen Bauteilen.

**3.** Verfahren zur Herstellung epitaktischer Schichten auf Substraten durch Elementabscheidung aus der Gasphase, dadurch gekennzeichnet, daß zur Abscheidung von Elementen der V. Hauptgruppe borhaltige organische Gruppe-V-Verbindungen der Formeln I, II, III oder IV gemäß Anspruch 1 eingesetzt werden .

**4.** Verfahren nach Anspruch 3, dadurch gekennzeichnet, daß während des Abscheidungsprozesses andere metallorganische Verbindungen, die unter den angewandten Reaktionsbedingungen gasförmig sind, zugesetzt werden.

**Claims**

**1.** Use of boron-containing organic group-V compounds of the formulae I, II, III or IV

$$(R^1)_{3-m}E(X\text{-}BR^2R^3)_m \qquad I$$

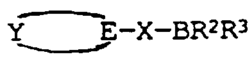

II

$$(R^5)_3EB(R^6)_3 \qquad III$$

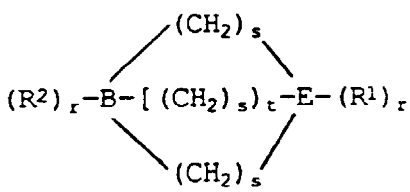

IV

wherein

| | |
|---|---|
| E | is nitrogen, phosphorus, arsenic or antimony, |
| m | is 1, 2 or 3, |
| X | is $-(CHR^4)_n-$ |

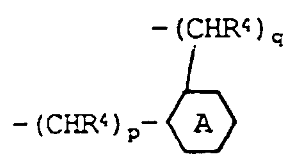

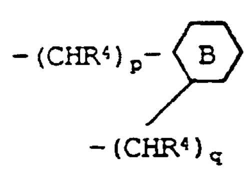

| | |
|---|---|
| A | is a phenyl, cyclohexyl, cyclohexenyl or cyclohexadienyl ring, |
| A' | is a cyclopentyl, cyclopentenyl or cyclopentadienyl ring, |
| n | is 1, 2, 3, 4, 5 or 6, |
| p and q | are each, independently of one another, 0, 1, 2, 3 or 4, |
| Y | is an alkylene or alkylidene group having 3-7 C atoms, in which one or more H atoms may also be replaced by $R^5$, and the alkylidene group possibly containing one or more non-adjacent double bonds, |
| s | in each case is 1, 2, 3 or 4, |

| | |
|---|---|
| r and t | are each 0 or 1, whilst |
| r + t | is 1, |
| $R^1$, $R^2$, $R^3$, $R^5$ and $R^6$ | are each, independently of one another, H, an alkyl group having up to 8 C atoms, which group may be partially or completely fluorinated, a cycloalkyl or cycloalkenyl group having 3-8 C atoms or an aryl group and |
| $R^4$ | in each case is H or an alkyl group having 1-4 C atoms which may also be partially or completely fluorinated for the preparation of epitaxial layers by elemental deposition from the gas phase. |

**2.** Use of the compounds according to Claim 1 for the fabrication of epitaxial layers in electrical, electronic, optical and optoelectric components.

**3.** Process for preparing epitaxial layers on substrates by elemental deposition from the gas phase, characterized in that boron-containing organic group-v compounds of the formulae I, II, III or IV according to Claim 1 are employed for the deposition of elements of the Vth main group.

**4.** Process according to Claim 3, characterized in that during the deposition process other organometallic compounds are added which are gaseous under the reaction conditions used.

## Revendications

**1.** Utilisation de composés organiques du groupe V contenant du bore de formules I, II, III ou IV

$$(R^1)_{3-m}E(X\text{-}BR^2R^3)_m \qquad I$$

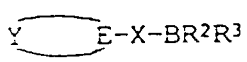

II

$$(R^5)_3EB(R^6)_3 \qquad III$$

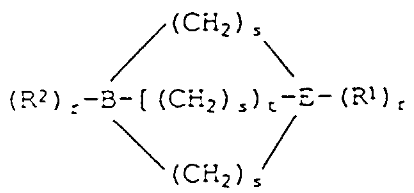

IV

dans lesquelles

| | |
|---|---|
| E | représente l'azote, le phosphore, l'arsenic ou l'antimoine, |
| m | vaut 1, 2 ou 3, |
| X | représente $-(CHR^4)_n-$ |

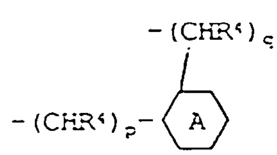

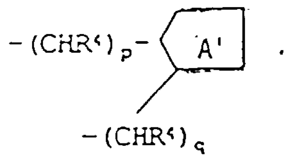

| | |
|---|---|
| A | représente un noyau phényle, cyclohexyle, cyclohexényle ou cyclohexadiényle, |
| A' | représente un noyau cyclopentyle, cyclopentényle ou cyclopentadiényle, |
| n | vaut 1, 2, 3, 4, 5 ou 6, |
| p et q | valent chacun indépendamment l'un de l'autre 0, 1, 2, 3 ou 4, |
| Y | représente un groupe alkylène ou alkylidène comportant de 3 à 7 atomes de carbone, où également un ou plusieurs atomes d'hydrogène peuvent être remplacés par $R^5$, une ou plusieurs doubles liaisons non voisines pouvant être présentes dans le groupe alkylidène, |
| s | vaut à chaque fois 1, 2, 3 ou 4, |
| r et t | valent à chaque fois 0 ou 1, où $r + t = 1$, |
| $R^1$, $R^2$, $R^3$, $R^5$ et $R^6$ | représentent chacun indépendamment l'un de l'autre H, un groupe alkyle ayant jusqu'à 8 atomes de carbone, ce groupe pouvant être partiellement ou entièrement fluoré, un groupe cycloalkyle ou cycloalcényle ayant de 3 à 8 atomes de carbone ou un groupe aryle<br>et |
| $R^4$ | représente à chaque fois H ou un groupe alkyle ayant de 1 à 4 atomes de carbone, qui peut également être partiellement ou entièrement fluoré, |

pour la préparation de couches épitactiques par séparation d'éléments à partir de la phase gazeuse.

**2.** Utilisation des composés selon la revendication 1 pour préparer des couches épitactiques dans les composants électriques, électroniques, optiques et opto-électriques.

**3.** Procédé de préparation de couches épitactiques sur des substrats par séparation d'éléments à partir de la phase gazeuse, caractérisé en ce que pour séparer des éléments du Vème groupe principal on utilise des composés organiques du groupe V contenant du bore de formules I, II, III ou IV selon la revendication 1.

**4.** Procédé selon la revendication 3, caractérisé en ce qu'au cours du processus de séparation on ajoute d'autres composés organo-métalliques qui sont gazeux dans les conditions réactionnelles appliquées.